(19)

**Europäisches Patentamt**
**European Patent Office**
**Office européen des brevets**

(11) **EP 1 775 840 B1**

(12) **EUROPEAN PATENT SPECIFICATION**

(45) Date of publication and mention
of the grant of the patent:
**30.08.2017 Bulletin 2017/35**

(51) Int Cl.:
*H03M 13/00* (2006.01)          *H04L 1/08* (2006.01)
*H04L 1/00* (2006.01)          *H03M 13/27* (2006.01)

(21) Application number: **05022598.6**

(22) Date of filing: **17.10.2005**

(54) **Transmitter, receiver and method with user-specific interleavers**

Sender, Empfänger und Verfahren mit teilnehmerspezifischen Interleavern

Émetteur, récepteur et méthode avec des entrelaceurs spécifiques aux utilisateurs

(84) Designated Contracting States:
**DE GB**

(43) Date of publication of application:
**18.04.2007 Bulletin 2007/16**

(73) Proprietor: **NTT DOCOMO, INC.**
**Chiyoda-ku**
**Tokyo 100-6150 (JP)**

(72) Inventors:
• **Kusume, Katsutoshi**
**80687 München (DE)**
• **Bauch, Gerhard**
**80799 München (DE)**

(74) Representative: **Zinkler, Franz et al**
**Schoppe, Zimmermann, Stöckeler**
**Zinkler, Schenk & Partner mbB**
**Patentanwälte**
**Radlkoferstrasse 2**
**81373 München (DE)**

(56) References cited:
**EP-A- 1 154 577      WO-A-2004/114536**

• BAUCH G ET AL: "Parameter optimization, interleaving and multiple access in OFDM with cyclic delay diversity" VEHICULAR TECHNOLOGY CONFERENCE, 2004. VTC 2004-SPRING. 2004 IEEE 59TH MILAN, ITALY 17-19 MAY 2004, PISCATAWAY, NJ, USA,IEEE, US, 17 May 2004 (2004-05-17), pages 505-509Vol1, XP010764849 ISBN: 0-7803-8255-2
• LI PING ET AL: "On interleave-division multiple-access" COMMUNICATIONS, 2004 IEEE INTERNATIONAL CONFERENCE ON PARIS, FRANCE 20-24 JUNE 2004, PISCATAWAY, NJ, USA,IEEE, 20 June 2004 (2004-06-20), pages 2869-2873, XP010712289 ISBN: 0-7803-8533-0
• LEUNG W K ET AL: "INTERLEAVING-BASED MULTIPLE ACCESS AND ITERATIVE CHIP-BY-CHIP MULTIUSER DETECTION" IEICE TRANSACTIONS ON COMMUNICATIONS, COMMUNICATIONS SOCIETY, TOKYO, JP, vol. E86-B, no. 12, December 2003 (2003-12), pages 3634-3637, XP001191574 ISSN: 0916-8516

**Description**

The present invention relates to the field of wireless multiple access schemes, for example code division multiple access (CDMA) or interleave division multiple access (IDMA).

In last years iterative schemes based on the turbo principle have been studied in many research areas such as detection/decoding, equalization problems, and so on. Iterative multi-user detection techniques have been intensively studied, especially in the area of CDMA. The iterative multi-user detection technique comprises a multi-user detector (MUD) and a bank of independent maximum a posteriori probability (MAP) decoders for multiple users. Multiple access interference (MAI) as well as inter symbol interference (ISI) is mitigated in an iterative fashion. Both multi-user detector and maximum a posteriori decoder are soft-in soft-out (SISO) blocks where they exchange soft information between each other over several iterations. In such an iterative receiver, the interleaver plays an important role and it has been noted in literature that the performance generally improves when for each user , for example, the transmitter interleaves a bitstream after channel encoding using a user-specific interleaver.

To the authors' knowledge, generally interleavers for such systems are randomly chosen and there are very few papers on design of multiple interleavers, e.g. from S. Brück, U. Sorger, S. Gligorevic, and N. Stolte, "Interleaving for outer convolutional codes in DS-CDMA systems," IEEE Transactions on Communications, vol. 48, no. 7, pp. 1100-1107, July 2000, in the following [1], and from A. Tarable, G. Montorsi, and S. Benedetto, "Analysis and design of interleavers for iterative multi-user receivers in coded CDMA systems," IEEE Transactions on Information Theory, vol. 51, no. 5, pp. 1650-1666, May 2005, in the following [2], while there has been a relatively large number of research results about single interleaver design for turbo codes.

The IDMA system has a close relation to CDMA, but users are separated only by user-distinct interleavers. Hence, the design of multiple interleavers is even more critical for IDMA than for CDMA. IDMA has, for example, been described by L. Ping, L. Liu, K. Y. Wu, and W. K. Leung, "Interleave-division multipleaccess," submitted to IEEE Transaction on Wireless Communications, in the following [3], by H. Schoeneich and P. A. Hoeher, "Adaptive interleave-division multiple access - a potential air interface for 4G bearer services and wireless LANs," in Proc. 1st IEEE and IFIP Int. Conf. on Wireless and Optical Communications and Networks (WOCN '2004), June 2004, pp. 179-182, in the following [4], and by K. Kusume and G. Bauch, "CDMA and IDMA: Iterative multi-user detections for near-far asynchronous communications," in Proc. IEEE Int. Symposium on Personal, Indoor and Mobile Radio Communications (PIMRC 2005), September 2005, to appear, in the following [5].

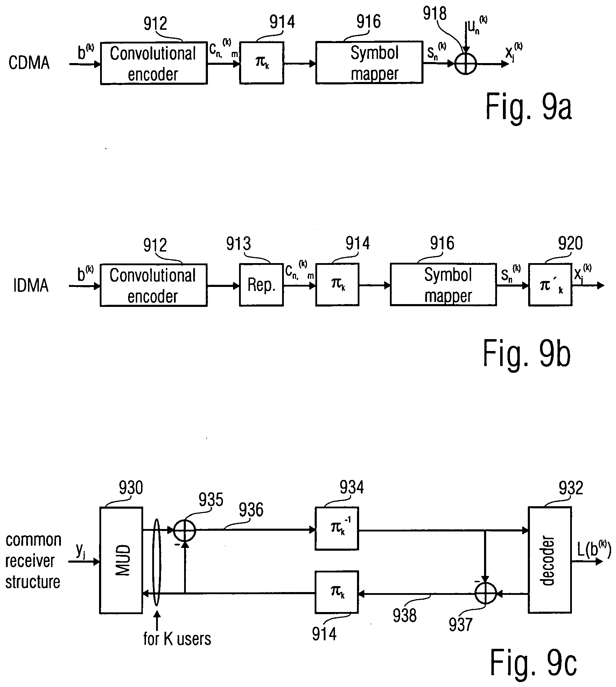

Exemplary CDMA systems or IDMA systems are explained based on Figs. 9A to 9C.

Fig. 9A shows a typical CDMA transmitter comprising a convolutional encoder 912, a user-distinct or user-specific interleaver $\Pi_k$ 914, a symbol mapper 916 and a code spreader 918. At the transmitter the information bits $b^{(k)}$ of user k, k = 1, ..., K, are encoded by the convolutional encoder 912 by the rate $R_c$. The coded bits $c_{n,m}^{(k)}$ are output by the convolutional encoder 912, interleaved by the user-specific interleaver $\Pi_k$ 914, then mapped to symbols $s_n^{(k)}$ by the symbol mapper 916 and spread by spreading code $u_n^{(k)}$ at code spreader 918. The signals $x_j^{(k)}$ from K users are transmitted to a channel.

Figure 9B shows a typical IDMA transmitter comprising a convolutional encoder 912, a repetition encoder 913, the user-specific interleaver $\Pi_k$ 914, the symbol mapper 916 and an optional, second user-specific interleaver $\Pi'_k$ 920. At the IDMA transmitter, the information bits $b^{(k)}$ of user k, k = 1, ..., K, are encoded by the convolutional encoder 912 at the rate $R_c$ followed by an repetition encoding at the rate $R_r$ through repetition encoder 913. The coded bits $c_{n,m}^{(k)}$ output from repetition encoder 913 are interleaved by the user-specific interleaver $\Pi_k$ 914 and then mapped to modulation alphabets or symbols $s_n^{(k)}$ by symbol mapper 916. The second interleaver $\Pi'_k$ 920 may be also applied before the transmission, but it is not further discussed in the following document.

The channel can be described or modelled by a finite-length impulse response filter (FIR filter).

Figure 9C shows an exemplary receiver, which is similar for CDMA and IDMA, applying multi-user detection and decoding in an iterative manner. The common receiver structure shows an iterative multi-user detection circuit having a multi-user detector (MUD) 930 and for each user a user-specific iterative processing circuit, wherein each multi-user specific iterative processing circuit comprises a maximum a posteriori (MAP) decoder 932, a user-specific deinterleaver $\Pi_k^{-1}$ 934 and a first node 935 in a forward signal path 936, from the multi-user detector 930 to the maximum a posteriori decoder 932, and a second node 937 and a user-specific interleaver $\Pi_k$ 914 in a backward signal path 938, from the maximum a posteriori decoder 932 to the multi-user detector 930.

The input signal for the user-specific deinterleaver $\Pi_k^{-1}$ 934 is generated by subtracting the output signal of the user-specific interleaver $\Pi_k$ 914 from an output signal of the multi-user detector 930 at the first node 935. The input signal of the user-specific interleaver $\Pi_k$ 914 is generated by subtracting the output signal of the user-specific deinterleaver $\Pi_k^{-1}$ 934 from an output signal of the maximum a posteriori decoder 932 at the second node 937.

The multi-user detector computes an *a posteriori* log-likelihood ratio (a posteriori LLR) for the coded bits based on an *a priori* log-likelihood ratio from the decoder. After subtracting the *a priori* log-likelihood ratio (a priori LLR) from the *a posteriori* log-likelihood ratio, the extrinsic information about the coded bits is deinterleaved and sent to the decoder.

The multi-user detector for IDMA is rather simple. Detailed descriptions of a multi-user detector for IDMA can be found, e.g. in [3], [5].

Since the information bits are encoded by a convolutional code followed by a repetition code, maximum a posteriori (MAP) decoding comprises two parts: decoding of the repetition code, which is to simply sum up every $1/R_r$ log-likelihood ratios, and decoding of the convolutional code by a standard function as described, e.g. from L. R. Bahl, J. Cocke, F. Jelinek, and J. Raviv, "Optimal decoding of linear codes for minimizing symbol error rate," IEEE Transactions on Information Theory, vol. 20, no. 2, pp. 284-287, March 1974, in the following [6]. The soft output from the maximum a posteriori (MAP) decoder 932 of the convolutional code is repetition coded and sent to the multi-user detector (MUD) 930 after subtracting the a *priori* log-likelihood ratio and the interleaving. In the following, the focus will be set on the generation of user-distinct multiple interleavers $\Pi_k$ 914.

The construction or design of single interleavers for turbo codes has been relatively well-studied in the last years and many proposals can be found in the literature. Here, two proposals are briefly reviewed: the UMTS interleaver, described in 3G TS 25.212, "3rd generation partnership project; technical specification group radio access network; multiplexing and channel coding (FDD) (release 1999)," March 2000, in the following [7], and the dithered golden interleaver described by S. Crozier, J. Lodge, P. Guinand, and A. Hunt, "Performance of turbocodes with relative prime and golden interleaving strategies," in Proceedings of the International Mobile Satellite Conference, 1999, pp. 268-275., in the following [8].

The UMTS turbo interleaver involves a few steps. Input bits are read into a rectangular matrix row by row, then intra-row and inter-row permutations are performed on the rectangular matrix. After the permutations, bits are read out from the rectangular matrix column by column. All these operations are described in [7] in detail and depend on the given interleaver size.

The dithered golden interleaver as described in [8] is a regular structure with some additional randomness. The indices of the interleaver size of N are calculated by sorting the following values:

$$p(n) = s + nc + d(n) \bmod N \text{ for } n = 0, \ldots, N - 1,$$

where s is any real starting index, d(n) is the n-th dither component which is generated from a uniform distribution between 0 and NW, where W is a normalized width of the dither distribution. The real valued c is computed as

$$c = N(g^m + q)/r,$$

where $g = (\sqrt{5} - 1)/2 \approx 0.618$ is the golden section value, m is any positive integer greater than zero, r is the index spacing between nearby elements to be maximally spread, and q is any integer modulo r [8]. As suggested in [8] for a typical implementation, the following parameters are used in the simulations later: $s = 0, m = 1, q = 0, r = 1, W = 0.01$.

In contrast to the single interleaver design, there have been very few studies about multiple interleavers [1], [2]. In [1] the authors proposed certain criteria to find multiple interleavers for convolutionally coded CDMA systems where the interleavers are limited to congruential interleavers due to its mathematical tractability. The idea is to choose user-specific congruential interleavers for a given convolutional code having certain free distance (common for all users) such that the resulting interleavers provide a good asymptotic distance of codes after interleaving; ideally close to the free distance so that the single user performance may be approached. This method requires computer search that becomes quite intensive for a large number of users.

In [2] several empirical criteria of goodness of a set of interleavers were proposed. The first approach is, similar to [1], to find interleavers such that users' codewords after interleaving should be as much as possible different to each other. As noted in [2], no deterministic recipe to construct optimal interleavers is provided. Then, a scope of finding interleavers is limited to congruential interleavers where the interleaver size is suggested to be a prime number so that the choice of multiple congruential interleavers becomes easy. As the second criterion, an iterative decoding suitability measure was proposed that takes into account correlations of log-likelihood ratios (LLRs), but it is defined only for a case of two users. Moreover, no deterministic method to generate good interleavers according to the second criterion was provided, therefore intensive computer search is necessary.

Summarising the state of the art, it can be said that a large amount of data is necessary to express an interleaver or interleaver algorithm. Assuming a naive implementation $n\log_2(n)$ bits for a frame size of *n* are necessary, for example for IDMA with blocks of 2.048 information bits, 1/2 convolutional code, 1/16 repetition code this results in a frame size of $n = 65.536$ bits after coding, which again leads to $n\log_2(n) = 1$ Mbits to express the interleaver.

Considering additionally that a large number of interleavers is required for a normal operation, because each of the K users needs a user-specific interleaver, and that furthermore the respective interleavers depend on various parameters, for example frame or packet sizes and coding rates, it can be easily seen that a large amount of memory and/or a high processing power is required.

There are very few studies in literature about multiple interleaver design, as most of the documents discuss single interleaver design, for example for turbocodes. Concerning multiple interleaver design, the interleavers described in most documents are completely randomly chosen. Therefore, intensive search and optimisation is necessary to define multiple interleavers based on the aforementioned state of the art methods. On the other hand, as these multiple interleavers are chosen randomly, they are not suitable for practical systems, as practical systems require clearly defined ways and methods to generate such interleavers.

The document WO 2004/114536 A describes a transmitter, wherein respective bit sequences are encoded by encoders to produce coded sequences which are then interleaved by respective interleavers to generate interleaved sequences. The latter are furthermore modulated by modulators to generate respective sequences of modulated symbols. In one specific example, the encoders are turbo encoders, i.e. turbo-systematic recursive convolutional encoders, wherein one or more, but not all have an interleaver at the input. Each user has the same interleaving pattern.

The document by Bauch G. et al.: "Parameter Optimization, Interleaving and Multiple Access in OFDM with Cyclic Delay Diversity" describes a transmitter for cyclic delay diversity encoded OFDM, wherein the data to be transmitted is first encoded by a FEC encoder, then interleaved by interleaver, then modulated by a symbol mapper, for example on QAM or PSK symbols, then processed by an inverse fast Fourier transform (IFFT) and then split on different antennas, wherein each antenna introduces a different cyclic delay. Finally, a guard interval is included and the data transmitted.

The Document EP 1 154 577 A describes an apparatus for reducing the information error rate of the communication network comprising a selector device coupled to a framer and to an interleaver. The selector device is configured to receive system information and the framer is configured to receive user information. The apparatus is coupled to equipment which operates the communication network based on system parameters. The apparatus improves the coding and effectively increases the interleaving depth applied to user information thus reducing the information error rate of the communication network without having to alter or modify any of the system parameters.

The publication US 2004/0240378 A1 describes a method for spread space-spectrum multiple access (SSSMA), where for each user its own digital data input to the system is generated. These independent data streams are encoded using a single-input-single-output channel (SISO) coding scheme. The outputs from each encoder are interleaved prior to entering the SSSMA-multiplexer, where the data streams from the user-specific interleavers are each modulated with a unique space-time-diagonal (STD) spreading sequence.

It is the object of the present invention to provide an efficient multiple interleaver design for user-specific interleavers.

This object is achieved by a user-specific interleaver of claim 1, by an iterative multi-user detection circuit of claim 6, by a method of claim 10, 11 or 12, and by a computer readable medium of claim 13.

The present invention provides a transmitter for generating information including a plurality of information blocks suitable for transmission to a receiver, comprising a user-specific interleaver, said user-specific interleaver comprising a common interleaver common to a plurality of users for interleaving information blocks and a user-specific permuting means for user-specifically permuting information blocks.

The present invention provides furthermore a transmitter for generating information including a plurality of information blocks suitable for transmission to a receiver, comprising a user-specific interleaver, operative to perform a user-specific interleaving algorithm, wherein the user-specific interleaver causes a user-specific interleaving of said information blocks which is equal to an interleaving caused by a common interleaver common to a plurality of users for interleaving information blocks and a user-specific permuting means for user-specifically permuting information blocks.

The present invention provides a receiver for iteratively processing information interleaved in a user-specific manner, said receiver comprising an iterative multi-user detection circuit having for each user a user-specific deinterleaver in a forward signal path and a user-specific interleaver in a backward signal path, wherein each user-specific interleaver comprises a common interleaver common to a plurality of users for interleaving information blocks and a user-specific permuting means for user-specifically permuting information blocks, and wherein each user-specific deinterleaver comprises a second user-specific permuting means for user-specifically permuting information blocks, and a common deinterleaver common to a plurality of users for deinterleaving information blocks.

The present invention provides furthermore a receiver for iteratively processing information interleaved in a user-specific manner, said receiver comprising an iterative multi-user detection circuit having for each user a user-specific deinterleaver in a forward signal path and a user-specific interleaver in a backward signal path, wherein each user-specific deinterleaver is operative to perform a user-specific deinterleaving algorithm, wherein the user-specific deinterleaver causes a user-specific deinterleaving of said information blocks which is equal to a user-specific deinterleaving caused by a first user-specific permuting means for user-specifically permuting information blocks and a common interleaver common to a plurality of users for deinterleaving information blocks, and wherein said user-specific interleaver is operative to perform a user-specific interleaving algorithm, wherein said user-specific interleaver causes a user-specific interleaving of said information blocks which is equal to a user-specific interleaving caused by a common interleaver common to a plurality of users for interleaving information blocks and a user-specific permuting means for user-specifically permuting information blocks.

The present invention provides a method of transmitting information including a plurality of information blocks to a receiver, comprising user-specific interleaving of information blocks, said user-specific interleaving step comprises the steps of a common interleaving of information blocks, said common interleaving being common to a plurality of users, and user-specific permuting of information blocks.

The present invention provides a method of iteratively processing information interleaved in a user-specific manner, said method comprising an iterative multi-user detection performing for each user a user-specific deinterleaving in a forward signal processing and a user-specific interleaving in a backward signal processing, wherein each user-specific interleaving comprises the steps of a common interleaving of information blocks, said common interleaving being common to a plurality of users, and user-specific permuting of information blocks, and wherein each user-specific deinterleaving comprises the steps of user-specific permuting of information blocks and common deinterleaving of information blocks, said interleaving being common to a plurality of users.

The present invention provides a method of exchanging user-specific interleaver parameters between a transmitter according to claims 1 or 5 and a receiver according to claims 7 or 9, said method comprising the following steps: generating the user-specific interleaver parameters at the transmitter randomly; sending the user-specific interleaver parameters from the transmitter to the receiver; evaluating the received user-specific interleaver parameters at the receiver; and rejecting the user-specific interleaving parameters in case the received user-specific interleaver parameters interfere with user-specific interleaver parameters of another user, or otherwise accepting the user-specific interleaving parameters; wherein the user-specific interleaver parameters comprise information concerning a frequency for updating said user-specific interleaving parameters between said transmitter and said receiver.

Furthermore, the present invention provides a computer program having a program code for performing one of the inventive methods, when the program runs on a computer.

The present invention is based on the finding that certain user-specific delays can already be helpful in terms of user separation when a common interleaver common for all users is used for interleaving. Although the user-specific delay is effective for user separation, it is generally difficult to control users' transmission timing. Therefore, instead of controlling the transmission timing of users a user-specific cyclic delay additionally to a common interleaver common for a plurality of users by analogy has been studied as an example.

Inventive transmitters, receivers and methods comprise or are based on a user-specific interleaver, which interleaves the information blocks in such a way that the result of the interleaving process is equal to an interleaving by a common interleaving and an additional user-specific permutation. This can be achieved by either performing two consecutive steps of processing, i.e. interleaving the information blocks by a common interleaver and in another step permuting the information blocks additionally, or deriving from the common interleaver and parameters of the additional user-specific permutation a user-specific interleaver which generates the same interleaving result like the two aforementioned separate steps in a single processing step.

Preferred embodiments of transmitters, receivers and methods comprise or are based on a user-specific interleaving which provides the same interleaving results as two or three of the aforementioned combinations of distinctive processing steps, i.e. common interleaving and permuting, or two or three respective units of a common interleaver and a user-specific permuting means. Again, this can be achieved by performing four or six distinctive processing steps or by deriving a user-specific interleaving algorithm which provides the same interleaving results in one single step. The respective permutations for one user-specific interleaving may be the same or different ones. Further preferred embodiments of transmitters, receiver or methods are operative to perform one or a plurality of cyclic shifts as the additional permutation.

The invention can be used especially in uplinks of cellular systems and decentralised systems like ad hoc networks where multiple users are accessing common frequency resources simultaneously.

The inventive method requires little computational effort to generate multiple interleavers for a large number of users and various rates of convolutional codes and repetition codes. Since it is based on a single common interleaver, one can easily make use of well-studied single interleavers, some of which are already implemented and available in standardized systems. Moreover, no additional storage is necessary to support a large number of interleavers. For example, only a few cyclic shifts determine each interleaver, thus, little information exchange is necessary among the transceivers. All these favoured properties of the inventive method are also of advantage in decentralized systems where strict management/assignment of multiple interleavers among transceivers is a difficult task. In such a scenario, instead of managing the distribution of interleavers, randomly chosen interleavers based on the described strategy can be used only in an agreement among relevant transceivers. In addition, the interleaver may be frequently updated over time, thus avoiding a collision of interleavers. Such a frequent update of interleavers can be realized, for instance, by exchanging a random seed, from which all relevant transceivers generate a few random cyclic shifts to update the interleaver.

Preferred embodiments of the present invention are described in detail with respect to the following figures:

Fig.1A     shows a model of a multi access channel with noise for K = 4 users accessing the channel with common interleavers;

Fig.1B     shows the same scenario as Fig. 1A except that for each user a user-specific delay $\tau_1$ to $\tau_4$ is added;

Fig.1C     shows the bit error rate performance of IDMA on an additive white gaussian noise channel for four synchronous users for random interleavers and for a common random interleaver;

Fig. 1D     shows the bit error rate performance of IDMA on an additive white gaussian noise channel for four asynchronous users for random interleavers and for a common random interleaver;

Fig. 2A     shows a multi access channel like Fig. 1A with multi-path characteristics;

Fig. 2B     shows a multi access channel like Fig. 1B with multi-path characteristics;

Fig. 2C     shows the bit error rate performance of IDMA on a multi-path channel for four synchronous users for random interleavers and for a common random interleaver;

Fig. 2D     shows a bit error rate performance of IDMA on a multi-path channel for four asynchronous users for random interleavers and for a common random interleaver;

Fig. 3A     shows a sequence of a common interleaver and a user-specific delay;

Fig. 3B     shows a combination of a common interleaver and a user-specific cyclic delay forming a user-specific interleaver;

Fig. 3C     shows a repetition of combinations shown in Fig. 3B forming a user-specific interleaver;

Fig. 3D     shows a combination of a user-specific cyclic inverse delay and a common deinterleaver forming a user-specific deinterleaver;

Fig. 3E     shows a sequence of combinations shown in Fig. 3D forming a user-specific deinterleaver;

Fig. 4     shows a preferred embodiment of an inventive IDMA transmitter;

Fig. 5A     shows the bit error rate performance of IDMA on an additive white gaussian noise channel for four synchronous users and two randomly chosen cyclic shifts per user;

Fig. 5B     shows a bit error rate performance of IDMA on a multi-path channel for four synchronous users and two randomly chosen cyclic shifts per user;

Fig. 6     shows a bit error rate performance of IDMA on an additive white gaussian noise channel for six synchronous users with one, two and three randomly chosen cyclic shifts per user;

Fig. 7     shows a bit error rate performance of IDMA on an additive white gaussian noise channel for 110 users transmitting synchronously with 5, 15, 25 and 30 iterations;

Fig. 8     shows a state diagram of a preferred embodiment of a method for exchanging parameters for a user-specific interleaver between a transmitter and a receiver;

Fig. 9A     shows an exemplary CDMA transmitter;

Fig. 9B     shows an exemplary IDMA transmitter; and

Fig. 9C     shows an exemplary receiver, common for CDMA and IDMA.

Unlike the previous works [1], [2] the invention does not attempt to optimise multiple interleavers. The described approach is rather an empirical design based on some observations which will be described in the following. It is first investigated what separates users, in particular, the impact of user asynchronism, or in other words, the asynchronous transmission of users is of interest. To this end, computer simulations as described in the following have been performed.

As discussed before based on the Figs. 9A to 9C, the signals $x_j^{(k)}$ are transmitted over a multi-path channel which can be modelled by a finite impulse response filter with $\nu_k$ delay elements to describe $\nu_k + 1$ channels each weighed with a user-specific channel tap. The multiple access multi-path channel is then modelled by superposing the outputs of the user-specific multi-path channels modelled by the aforementioned finite impulse response filters and adding gaussian noise. The received signal $y_j$ can be expressed as

$$ y_j = \sum_{k=1}^{K} \sum_{\ell=0}^{\nu_k} g_{k,l} x_{j-\tau_k-\ell}^{(k)} + \eta_j, $$

where $\tau_k$ is a user-specific delay, $g_{k,1}$ and $\nu_k$ are respectively the complex valued channel tap and memory of the multipath channel of user k. Complex valued noise is denoted by $\eta_j$ which is zero-mean Gaussian distributed and has a variance of $N_0/2$ per real dimension.

Referring to Figs. 9A to 9C, information bits of frame length 128 are encoded by the rate $R_c = 1/2$ memory 4 standard convolutional code with generator polynomial $[23, 35]_8$. The trellis of the convolutional encoder is terminated that requires 4 additional termination bits, resulting in 264 coded bits. The coded bits are further encoded by the rate $R_r = 1/4$ repetition code that gives 1056 coded bits. Thus, the resulting interleaver size is 1056. Note that, in order to have a balanced number of zeros and ones, the repetition code yields alternating bits, namely $0 \rightarrow 0101$ and $1 \rightarrow 1010$ for all users.

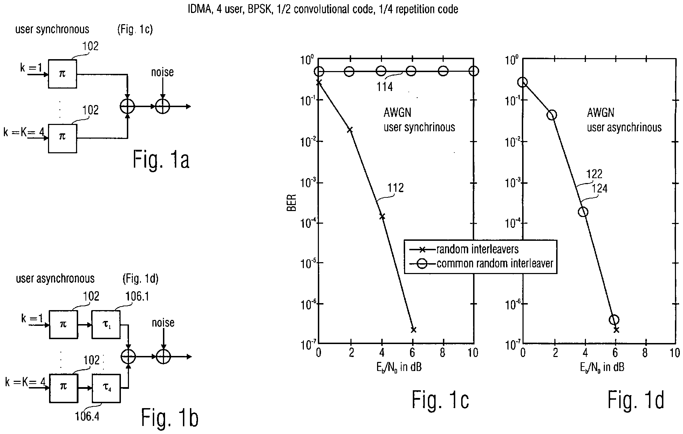

Figure 1A shows a model of a multi access channel with additive noise 104 for K = 4 users accessing the channel with common interleavers 102 transmitting synchronously.

Figure 1B shows the same scenario as Fig. 1A, wherein for each user a user-specific delay $\tau_1$ 106.1 to $\tau_4$ 106.4 is added.

Figs. 1C and 1D show a bit error rate (BER) performance of IDMA on the additive white gaussian noise (AWGN) channel after six iterations. The signal to noise ratio (SNR) per bit $E_b/N_0$ in dB is represented by the x-axis and the bit error rate (BER) is represented by the y-axis.

The coding comprises 1/2 convolutioal coding, 1/2 repetition coding and the coded bits are BPSK (BPSK = Binary Phase Shift Keying) modulated. The K = 4 users are either transmitting synchronously, results shown in Fig. 1C, or asynchronously with user-specific delays of $\tau_k = k - 1$, as shown in Fig. 1B, wherein the results of the latter are shown in Fig. 1D,.

In each scenario, Fig. 1C and Fig. 1D, the performance is plotted for two cases in which either user-distinct multiple random interleavers or a single common random interleaver common for all users is used. In Fig. 1C plot 112 plots the bit error rate performance for random interleavers and plot 114 the bit error rate performance for a common random interleaver without user-specific delays in Fig. 1A. Plot 122 plots the bit error rate performance for random interleavers and plot 124 the bit error rate performance for a common random interleaver with user-specific delays in Fig. 1B.

The interleaver is randomly generated from uniform distribution and is newly generated for each transmission frame. The user-distinct multiple random interleavers for K users are generated independently of each other. It can be observed that the performance does not improve after iterations when using a single common interleaver in the user-synchronous case while the performance is as good as user-distinct multiple interleavers in the user-asynchronous case with the specific user delays of $\tau_k = k - 1$.

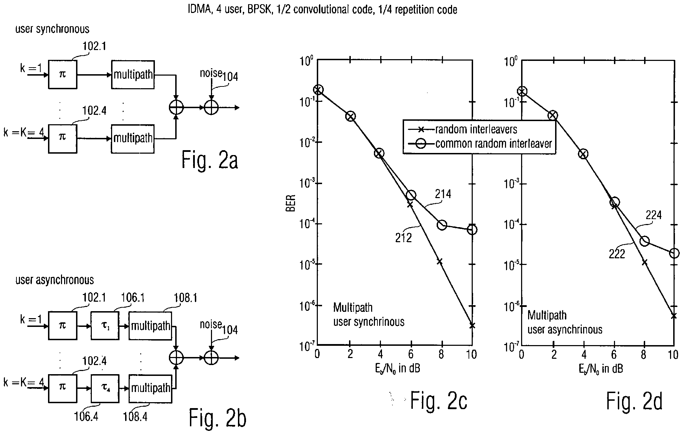

Figure 2A shows a multi access channel like Fig. 1A adding user-specific multi-path characteristics 108.1 to 108.4 to model a multi access multi-path channel with additive noise for a user-synchronous transmission.

Figure 2B shows a scenario with user specific delays 106.1 to 106.4 and a multi access channel like in Fig. 1B adding user-specific multi-path characteristics 108.1 to 108.4 to model a scenario with user-specific delays and multi access multi-path channel with additive noise for a user-asynchronous transmission.

Figures 2C and 2D show the bit error rate performance of IDMA on a multi-path channel after four iterations, K = 4 users transmitting either synchronously, refer to Fig. 2A, or asynchronously with user-specific delays of $\tau_k = k - 1$, refer to Fig. 2B. Coding comprises a 1/2 convolutional code and 1/4 repetition code. The coded bits are binary phase shift keying modulated. The channel delay is set as $\nu_k = 7$ for all K = 4 users. The channel taps are generated from zero mean Gaussian distribution with uniform power delay profile, i.e. $E[|g_{kl}|^2] = 1/(\nu_k + 1) = 1/8$ . The signal to noise ratio (SNR) per bit $E_b/N_0$ in dB is represented by the x-axis and the bit error rate (BER) is represented by the y-axis.

In both Figs. 2C and 2D the bit error rate performance is plotted for two cases in which either user-specific multiple random interleavers or a single common random interleaver common to all users with user-specific delays is used. In Fig. 2C the plot 212 plots the bit error rate performance for random interleavers and plot 214 plots the bit error rate performance for a common random interleaver. In Fig. 2D the plot 222 plots the bit error rate performance for random interleavers and plot 224 plots the bit error rate performance for a common random interleaver.

In contrast to the previous example of a perfectly user-synchronous case on an additive white gaussian noise channel, refer to Fig. 1C, the users are still separable, although not sufficient, even using a single common interleaver in the user-synchronous case, refer to Fig. 2A, due to the multi-path channel that is user-independent. The performance improves with the user-specific delays of $\tau_k = k - 1$, refer to Fig. 2D.

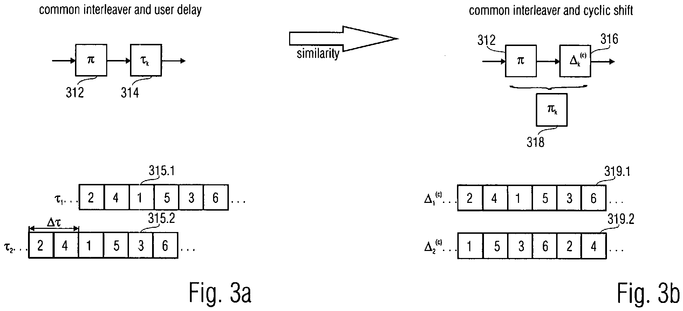

From the above observations, it was concluded that certain user-specific delays can be helpful in terms of user separation. That is due to the fact that the interleaver cycle is shifted so that the deinterleaving of a user does not recover the original sequence order of other users, thus the users' signals are made effectively uncorrelated to each other in a certain degree. Based on the observations, an efficient strategy to generate multiple interleavers is summarised in Figs. 3A to 3E.

Figure 3A shows a system for a user-specific interleaver with a common interleaver $\Pi$ 312 and a user-specific delay $\tau_k$ 314. Figure 3A shows furthermore a signal of user K = 1 with a user-specific delay $\tau_1$ and the same signal 315.2 of user 2 with a user-specific delay $\tau_2$, wherein the user-specific delays $\tau_1$ and $\tau_2$ are not equal and thus cause a delay difference of $\Delta\tau = \tau_1 - \tau_2$.

Although the user delay is effective for a user separation, it is generally difficult to control the users' transmission timing, e.g. in an uplink of cellular systems or decentralised systems like ad hoc networks. Therefore, instead of controlling the transmission timing or delays of users, the invention exploits, for example, a cyclic shift by analogy. That is depicted in Fig. 3B.

Figure 3B shows a combination or sequence of common a interleaver $\Pi$ 312 and a user-specific cyclic shift $\Delta_k^{(c)}$ 316 forming a user-specific interleaver $\Pi_k$ 318. Figure 3B shows furthermore signal 319.1 of user K = 1 with a cyclic shift of $\Delta_1^{(c)}$ and a signal 319.2 of user K = 2 with a cyclic shift $\Delta_2^{(c)}$, wherein the user-specific delays $\Delta_1^{(c)}$ and $\Delta_2^{(c)}$ are not equal.

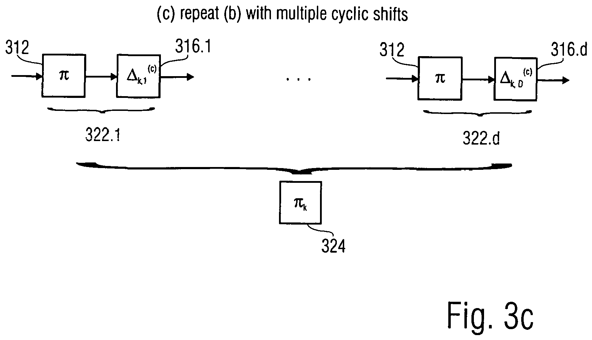

However, as it was observed in the computer simulations with certain user delays, only single cyclic delays may not be sufficient to separate users. Thus, multiple cyclic shifts with a common interleaver placed in between, or in other words, a sequence of combinations or units each comprising a common interleaver and a user-specific cyclic shift are proposed to construct a user-specific interleaver as illustrated in Fig. 3C.

Figure 3C shows a sequence of combinations 322.1 to 322.D, wherein D is the number of consecutive combinations 322, each comprising the same common interleaver $\Pi$ 312 and a user-specific cyclic shift 316, wherein these multiple cyclic delays $\Delta_{k,1}^{(c)}$ 316.1 to 316. D may be different for each combination 322.1 to $\Delta_{k,D}^{(c)}$ 322. D, forming a user-specific interleaver $\Pi_k$ 324.

As will be shown later by simulation results, only two or three cyclic shifts, i.e. combinations of a common interleaver and user-specific cyclic shifts, will be sufficient for a good user separation.

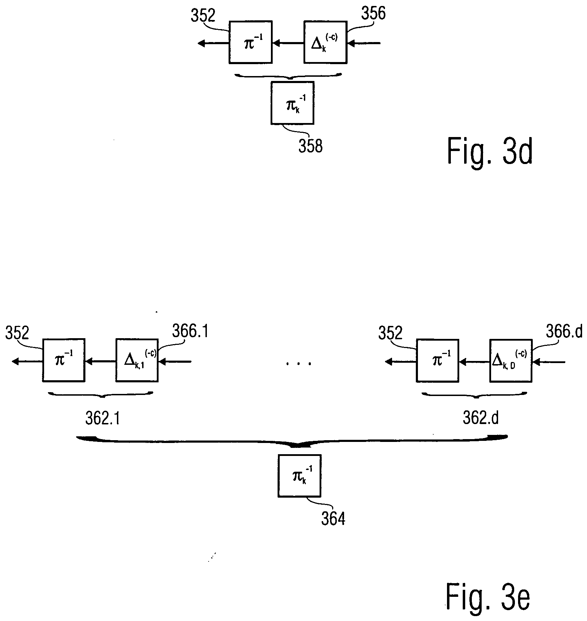

Figure 3D shows an equivalent realisation of a user-specific deinterleaver $\Pi_k^{-1}$ 358 performing the reverse or inverse algorithm of the corresponding user-specific interleaver $\Pi_k$ 318 of Fig. 3B. The user-specific deinterleaver $\Pi_k^{-1}$ 358, therefore, can comprise a cyclic deshifter $\Delta_k^{(-c)}$ 356 performing the cyclic inverse shifting corresponding to the cyclic shifting performed by cyclic shift $\Delta_k^{(c)}$ 316 in Fig. 3B, and a common deinterleaver $\Pi^{-1}$ 352 performing the deinterleaving corresponding to the interleaving performed by the common interleaver $\Pi$ 312 according to Fig. 3B. The distinct operations of cyclic inverse shifting and deinterleaving are performed in a reverse manner or direction compared to the steps of interleaving and cyclic shifting as shown in Fig. 3B.

Figure 3E shows a possible realisation or signal flow of a user-specific deinterleaver $\Pi_k^{-1}$ 364 corresponding to the user-specific interleaver $\Pi_k$ 324 according to Fig. 3C. Similar to the user-specific interleaver $\Pi_k$ 324 of Fig. 3C, the user-specific deinterleaver $\Pi_k^{-1}$ 364 comprises a sequence of combinations 362.1 to 362.D. But these combinations comprise correspondingly a user-specific inverted cyclic shift, or in other words a cyclic deshift, $\Delta_{k,1}^{(-c)}$ 316.1 to $\Delta_{k,D}^{(-c)}$ 316. D, and a common deinterleaver $\Pi^{-1}$ 352. As explained for Fig. 3D, the user-specific deinterleaving can be described as performing the interleaving process in an inverse manner, thus, the user-specific cyclic inverse shift $\Delta_{k,D}^{(-c)}$ 316. D performs the inverse operation of user-specific cyclic shift $\Delta_{k,D}^{(c)}$ 316.D, etc., up to the user-specific cyclic inverse shift $\Delta_{k,1}^{(-c)}$ 366.1, and the common deinterleavers $\Pi^{-1}$ 312 the deinterleaving corresponding to the interleaving performed by the common interleavers $\Pi$ 312 according to Fig. 3C, and processing these steps in the inverse direction or manner compared to Fig. 3C. In other words, the user-specific deinterleaver $\Pi_k^{-1}$ 358, 364 undoes the interleaving of the user-specific interleaver $\Pi_k$ 318, 324.

In a preferred embodiment of the invention, the user-specific interleaving and user-specific deinterleaving are not processed as a sequence of individual steps, as one could consider looking at Figs. 3B to 3D, but are computed by the transmitter or receiver based on the common interleaver $\Pi_k$ 318, 324, based on only a few parameters, for example the number of cyclic shifts and number of bitshifts each cyclic shift comprises, and which for example are exchanged between the transmitter and the receiver, to derive a user-specific interleaver $\Pi_k$ 318, 324 producing the same interleaving result but in a single processing step.

Consider, for example, a user-specific interleaver $\Pi_k = \Delta_{k,2}\Pi\Delta_{k,1}\Pi$ where the common interleaver $\Pi$ is determined by the indices of **[3 5 1 6 2 4]** and the user specific cyclic shifts $\Delta_{k,1}$ and $\Delta_{k,2}$ are 1 and 3, respectively. There are three steps to get or compute the indices determining the respective $\Pi_k$ or algorithm which perform the user-specific interleaving in a single processing step. The first step is the cyclic shift by $\Delta_{k,1}$ that gives the indices **[5 1 6 2 4 3]**. Then, the indices are interleaved (permuted) by $\Gamma_\cdot$, which results in **[6 4 5 3 1 2]**. Finally, the indices are cyclically shifted by $\Delta_{k,2}$ so that one gets **[3 1 2 6 4 5]**. This process has to be performed only once, and then the resulting indices can be used as the interleaving rule or algorithm of the user-specific interleaver $\Pi_k$.

Methods to derive the corresponding deinterleaver for a specific interleaver, independently if this is for a common or for a user-specific interleaver, are known to one skilled in the art, and, therefore, are not further discussed in this document.

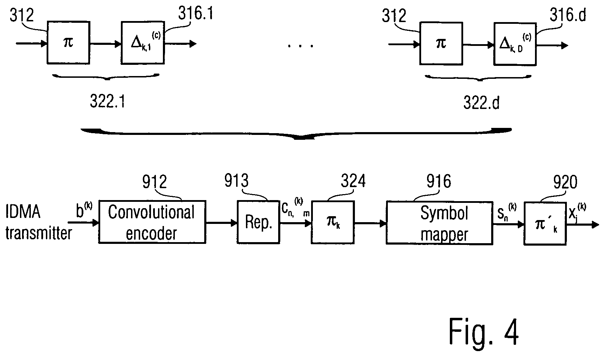

Figure 4 shows a preferred embodiment of an inventive IDMA transmitter which is similar to the transmitter shown in Fig. 9B. The sequence of combinations 322.1 to 322.D underlines that a preferred embodiment of a transmitter comprises two to three combinations 322 and that an inventive user-specific interleaver can be realised either as a user-specific interleaver performing the user-specific interleaving at one single processing step or as a sequence of distinct processing steps, comprising common interleaving and user-specific cyclic shifting. An inventive receiver can be depicted accordingly.

The invention has the advantage, as described before, that it provides an efficient and rather simple method to design and define user-specific interleavers and deinterleavers requiring only little computational effort for their generation. Additionally, only one common interleaver is needed as a basis for the design, thus allowing to utilise well-studied single-interleavers and not requiring any additional storage.

The invention supports many interleavers, or in other words, can be used with many well-known interleavers, like it will be shown in the following. Finally, the amount of data to be exchanged between a transmitter and a receiver is minimal and therefore it is easy to exchange the interleaver information or interleaver identifier (ID).

To evaluate the proposed strategy, computer simulations have been performed with the same parameters set as in Figs. 1A to 1D and Figs. 2A to 2D. In principle, any interleaver may be used for the single common interleaver. Here, the UMTS turbo interleaver (UMTS = Universal Mobile Telecommunication Standard) and the dithered golden interleaver described previously are just examples.

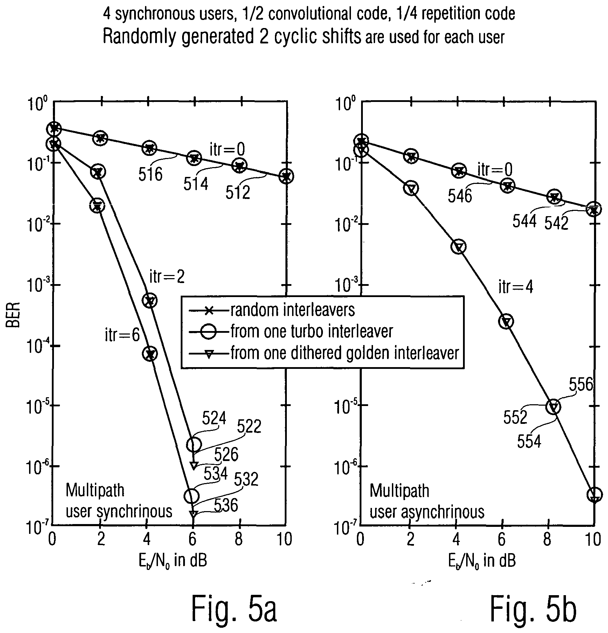

Figure 5A shows the IDMA bit error rate performance on additive white gaussian noise and Fig. 5B the bit error rate performance on a multi-path channel with 1/2 convolutional code, 1/4 repetition code, binary phase shift keying, wherein K = 4 users are synchronous, i.e. $\tau_k = 0, \forall k$. The signal to noise ratio (SNR) per bit $E_b/N_0$ in dB is represented by the x-axis and the bit error rate (BER) is represented by the y-axis.

Two user-specific cyclic shifts are used to generate multiple interleavers where the cyclic shifts are independently and randomly generated from a uniform distribution between 0 and N-1, wherein N defines the block length of an information block. These cyclic shifts are newly generated for each transmission frame.

In Fig. 5A the plot 512 shows the bit error rate performance for random interleavers with zero iterations (itr = 0), plot 514 shows the bit error rate performance for one common turbo interleaver with zero iterations and plot 516 shows the bit error rate performance for one common dithered golden interleaver after zero iterations. The plots 512, 514 and 516 are almost equal. In Fig. 5A the plot 522 shows the bit error rate performance for random interleavers after two iterations (itr = 2), plot 524 shows the bit error rate performance for one common turbo interleaver after two iterations and plot 526 shows the bit error rate performance for one common dithered golden interleaver. The plots 522, 524 and 526 are almost equal. In Fig. 5A the plot 532 shows the bit error rate performance for random interleavers after six iterations (itr = 6), plot 534 the bit error rate performance for one common turbo interleaver after six iterations and plot 536 the bit error rate performance for one common dithered golden interleaver after six iterations.

In Fig. 5B plot 542 shows the bit error rate performance for random interleavers after zero iterations (itr = 0), plot 544 shows the bit error rate performance for one common turbo interleaver after zero iterations and plot 546 shows the bit error rate performance for one common dithered golden interleaver after zero iterations. In Fig. 5B plot 552 shows the bit error rate performance for random interleavers after four iterations (itr = 4), plot 554 shows the bit error rate performance for one common turbo interleaver after four iterations and plot 556 shows the bit error rate performance for one common dithered golden interleaver after four iterations.

As can be observed from Figs. 5A and 5B, the inventive method of using one common interleaver in combination with cyclic shifts, here two cyclic shifts, is after two to six iterations effective to separate users and the performance is independently of the number of iterations as good as for the case of using randomly generated multiple interleavers.

The role of interleavers becomes even more important for highly loaded scenarios since more iterations are necessary to mitigate the multiple access interference.

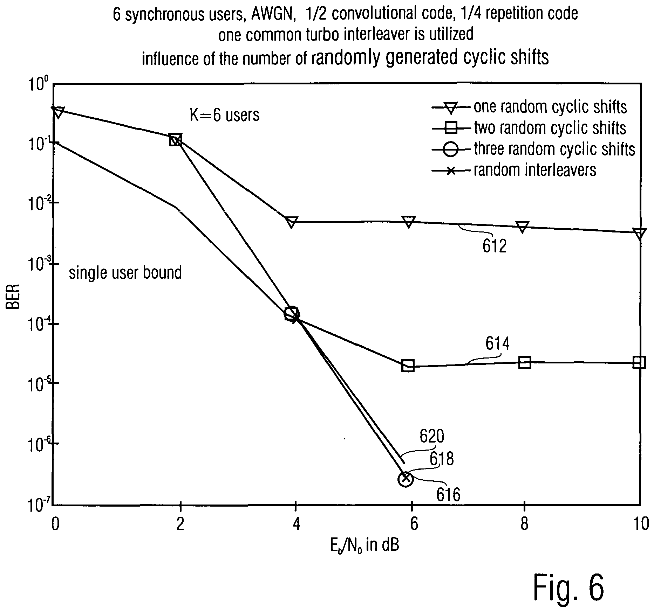

Fig. 6 shows the IDMA bit error rate performance performance on AWGN channel where K = 6 users are synchronous ($\tau_k = 0, \forall k$), with 1/2 convolutional code, 1/4 repetition code and wherein one common UMTS turbo interleaver is utilised. The coded bits are QPSK (Quadrature Phase Shift Keying) modulated.

The bit error rate performance after fourteen iterations is plotted for three cases, where one, two and three randomly chosen cyclic shifts are used to generate multiple interleavers together with the common UMTS turbo interleaver.

In Fig. 6 plot 612 plots the bit error rate performance for one random cyclic shift, plot 614 plots the bit error rate performance for two random cyclic shifts, plot 616 plots the bit error rate performance for three random cyclic shifts, plot 618 shows the bit error rate performance for multiple random interleavers and plot 620 plots the bit error rate performance for single user bound. As can be observed in Fig. 6, there are relatively high error floors using one or two random cyclic shifts, refer to plots 612 and 614. With three random cyclic shifts, refer to plot 616, the error floor cannot be observed in the error rate of practical interests. The error rate for three random cyclic shifts, refer to plot 616, is as good as for multiple random interleavers, refer to plot 618, and almost as good as for single user bound, refer to plot 620. A similar tendency was observed using the dithered golden interleaver, wherein the results are not shown here.

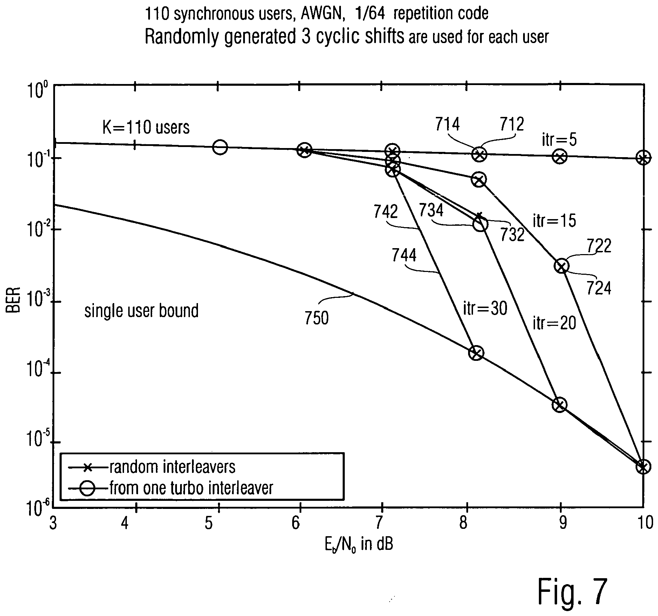

Furthermore, the case of a large number of users is of high interest. Figure 7 shows the bit error rate performance of IDMA with an additive white gaussian noise channel, wherein K = 110 transmit synchronously, $N_b$ = 256 information bits are coded only by a repetition code of rate $R_r$ = 1/64 and are then binary phase shift keying modulated. Therefore, the interleaver size is 16.384, wherein the user-specific interleavers are generated from three for each user randomly chosen cyclic shifts and the common UMTS turbo interleaver. The bit error rate performance is plotted after 5, 15, 20 and 30 iterations and compared with the case of independently and randomly generated multiple interleavers.

In Fig. 7 plot 712 shows the bit error rate performance for one common turbo interleaver after five iteration (itr = 5), and plot 714 the bit error rate performance for multiple random interleavers after five iterations. Plots 712 and 714 show a very similar bit error rate performance. In Fig. 7 plot 722 shows the bit error rate performance for one common turbo interleaver after fifteen iterations (itr = 15) and plot 724 the bit error rate performance for multiple random interleavers after fifteen iterations. The plots 722 and 724 show a very similar bit error rate performance. In Fig. 7 plot 732 shows the bit error rate performance for one common turbo interleaver after twenty iterations (itr = 20) and plot 734 the bit error rate performance for multiple random interleavers after 20 iterations. The plots 732 and 734 show very a similar bit error rate performance. In Fig. 7 plot 742 shows the bit error rate performance for one common turbo interleaver after 30 iterations (itr = 30) and plot 744 the bit error rate performance for multiple random interleavers after thirty operations. The plots 742 and 744 show a very similar bit error rate performance. Plot 750 shows the bit error rate performance for single user bound for reference.

As can be seen from Fig. 7, the performance of the user-specific interleavers generated by the inventive approach is, independent of the number of iterations, as good as that of the completely randomly generated multiple interleavers.

The inventive method requires little computational effort to generate multiple interleavers for a large number of users and for various rates of convolutional codes and repetition codes. It is a few cyclic shifts that determine each interleaver, thus little information exchange is necessary among transceivers. These are desired features to use IDMA in a practical system.

In decentralised systems where a system's topology dynamically changes, it is difficult to manage and assign multiple interleavers among transceivers or users. In such a scenario, instead of careful management of interleavers causing a large signaling overhead randomly chosen interleavers based on the inventive method can be used to avoid interleaver collisions. Furthermore, the interleaver may be frequently updated over time, thus to decrease the probability of interleaver collision. Such a frequent update of interleavers may be realised, for instance, by exchanging a random seed, from which all relevant transceivers generate a view random cyclic shifts to update the interleaver.

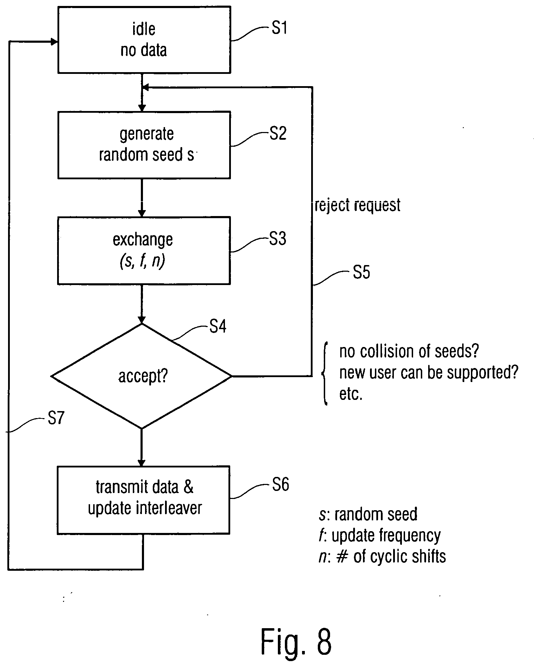

Figure 8 shows a state diagram of an embodiment of an inventive method for exchanging interleaver information between transceivers or in other words between a transmitter and a receiver. In step S1 a shift register for generating a pseudo noise sequence is idle and no data about a user-specific interleaver is agreed between the transmitter and the receiver. In step S2 the transmitter generates a random seed s, wherein the random seed s is a random setting of the shift register. In step S3 the parameters defining the user-specific interleaver are exchanged, i.e. the transmitter sends the random seed s, the update frequency f and the number of cyclic shifts n to the receiver. The update frequency f defines after how many frames a new user-specific interleaver is exchanged between transmitter and receiver, wherein the update frequency is an integer greater or equal to one, and wherein the number of cyclic shifts n defines the number of cyclic shifts corresponding to D in Fig. 3C, in other words defining the number of combinations 322 of the common interleaver $\Pi$ 312 and the user-specific cyclic shift $\Delta_k^{(c)}$. The initial random seed s, in other words the initial value of the shift register, defines the number of bits the information block is cyclicly shifted by the cyclic shift $\Delta_{k,1}^{(c)}$ 316.1 in Fig. 3C, wherein the shift length or number of bits the information block is shifted in the following user-specific cyclic shifts $\Delta_{k,2}^{(c)}$ 322.2 to $A_{k,D}^{(c)}$ 322.D are derived by the values of the shift register after the consecutive D-1 shifts of the shift register. The shift length of each cyclic shift may range from zero to the size of the interleaver.

In step S4 the transmitter evaluates based on given criteria whether to accept or reject the parameters for the user-specific interleavers transmitted by a transmitter. In case the receiver rejects the sent parameters, step S5, the transmitter generates a new random seat, step S2. In case the receiver accepts the parameters, the transmitter starts transmitting the data and the interleaver is updated according to the update frequency f, step S6. After the data has been transmitted, the transmission is terminated, step S7 and both, the transmitter and the receiver return to an idle state, step S1.

In other words, the transmitter generates a random seed s and exchanges with the receiver a three tuple (s, f, n) which determines a rule to generate interleavers where f and n respectively denote a frequency to update the interleaver and the number of cyclic shifts to generate a new interleaver. The receiver can decide whether the transmission request should be accepted based on certain criteria. The criteria are not limited to the collision of the random seed to other ongoing transmissions, but also, for example, may comprise the interference level or receiver's capability to handle interference simultaneous transmissions. If the transmission request is rejected by the receiver, the transmitter may repeat the same procedure.

Alternative methods to define, for example, the length of each cyclic shift, to define a frequency to update the interleaver, e.g. by defining a time instead of a frequency, and for the protocol to exchange the parameters are possible. Alternatively, the receiver may define the parameters for the user-specific interleaver upon request of a transmitter, for example in a scenario where the receiver is a base station, the base station serving a large number of users, thus only proposing parameters which do not collide with the parameters of user-specific interleavers already in use by the base station.

Although the described embodiments comprise one or a plurality of combinations of a common interleaver and user-specific cyclic shifts, alternatively any other permutation instead of the cyclic shift, which is in fact a kind of permutation, can be used.

The user-specific deshifting or inverse permuting for the user-specific deinterleaving can also be generally expressed or described as a permutation. Thus, more generally expressed, an inventive reveiver performs, for example, a first user-specific permutation for the user-specific interleaving and a second user-specific permutation for the user-specific deinterleaving.

Furthermore, although the examples and simulations focussed on IDMA, it goes without saying that the invention can also be used for CDMA transmitters and receivers with user specific interleavers.

Summarising the aforementioned using user-distinct or user-specific interleavers is an effective means to separate multiple users, e.g. in code division multiple access (CDMA) systems in addition to user-specific spreading codes. In interleave division multiple access (IDMA), which has a close relation to CDMA, but wherein users are separated only by user-specific interleavers, multiple, user-specific interleavers are essential system components. But also the performance of multiple access systems like CDMA generally improve when each user interleaves a bitstream after general encoding using a user-specific interleaver. Interleavers of such systems are randomly chosen in most literature. In practical systems, however, there must be a clearly defined way to generate such multiple user-specific interleavers.

Instead of optimising interleavers based on criteria and intensive computer search as proposed, e.g. in [1], [2] for given parameters such as block length or certain convolutional codes in use, the invention provides an efficient, empirical design motivated by observations from computer simulations.

The invention comprises using user-specific cyclic shifts or other permutations in combination with a single, common interleaver, which is common for all users, in order to generate multiple user-specific interleavers or interleaving algorithms. Although this is an empirical design and no optimality is claimed, computer simulation results showed that only a few, two or three, cyclic shifts are already sufficient for a good user separation.

Since the invention is based on a single common interleaver, one can easily make use of well-studied single interleavers, some of which are already implemented and available in standardised systems. Moreover, no additional storage is necessary to support a large number of interleavers, only little computational efforts and little information exchange are necessary.

Therefore, the invention is very efficient so that almost no additional software or hardware components are required which is of great benefit for commercial products.

Additionally, an effective strategy about information exchange for user-specific interleavers in decentralised networks has been described. The inventive method is based on randomising parameters rather than managing parameters or user-specific interleavers, comprises frequent updates of interleavers to avoid collisions, and exchanging of random seeds to generate random cyclic shifts wherein the receiver may reject the transmittors' requests in case of collision of random seed or other criteria.

Depending on certain implementation requirements of the inventive methods, the inventive methods can be implemented in hardware or in software. The implementation can be performed using a digital storage medium, in particular a disk, DVD or a CD having electronically readable control signals stored thereon, which cooperate with a programmable computer system such that the inventive methods are performed. Generally, the present invention is, therefore, a computer program product with a program code stored on a machine-readable carrier, the program code being operative for performing the inventive methods when the computer program product runs on a computer. In other words, the inventive methods are, therefore, a computer program having a program code for performing at least one of the inventive methods when the computer program runs on a computer.

**Claims**

1. User-specific interleaver suitable for use in a transmitter for generating information including a plurality of information blocks suitable for a transmission to a receiver, said user-specific interleaver (318, 324) comprising:

   an interleaver (312) arranged for interleaving information blocks according to an interleaving algorithm, the interleaving algorithm being the same for a plurality of users; and
   user-specific permuting means (316, 316.1 to 316.D) arranged for user-specifically permuting information blocks;
   wherein said user-specific permuting means (316, 316.1 to 316.D) is arranged consecutive to said interleaver (312) and arranged for permuting information blocks interleaved by said interleaver (312).

2. User-specific interleaver according to claim 1,
   wherein said permuting means comprises shift means (316, 316.1 to 316.D) arranged for cyclic shifting said information blocks.

3. User-specific interleaver according to one of the claims 1 or 2, wherein said user-specific interleaver (318, 324) comprises a sequence of units each comprising said interleaver (312) and said permuting means (316, 316.1 to 316.D).

4. User-specific interleaver according to claim 1,
   wherein said user-specific permuting means (316, 316.1 to 316.D) is arranged for user-specifically permuting information blocks according to a user-specific permutation.

5. User-specific interleaver according to claim 4,
   wherein said user-specific interleaver (324) comprises a sequence of units (322, 322.1 to 322.D), each said unit (322, 322.1 - 322.D) comprising said interleaver (312) and said user-specific permuting means (316, 316.1 to 316.D).

6. Iterative multi-user detection circuit for iteratively processing information interleaved in a user-specific manner, said iterative multi-user detection circuit comprising for each user:

   a user-specific deinterleaver (358, 364) in a forward signal path (936) between a multi-user detector (930) and a maximum a posteriori decoder (932); and
   a user-specific interleaver (318, 324) according to one of claims 1 to 5 in a backward signal path (938) between said maximum a posteriori decoder (932) and said multi-user detector (930);
   wherein each user-specific deinterleaver (358, 364) comprises a further user-specific permuting means (356, 366.1 to 366.D) arranged for user-specifically permuting information blocks, and a deinterleaver (352) arranged for deinterleaving information blocks for a plurality of users according to a deinterleaving algorithm, the deinterleaving algorithm being the same for said plurality of users; and
   wherein said deinterleaver (352) is arranged consecutive to said further user-specific permuting means (356, 366.1 to 366.D) and arranged for deinterleaving information blocks permuted by said further user-specific permuting means.

7. Iterative multi-user detection circuit according to claim 6, said receiver comprising a multi-user detector (930) and a plurality of user-specific iterative processing circuits (932), each iterative processing circuits (933) comprising:

   a first node (935) receiving from said multi-user detector (930) a posteriori log-likelihood signal;
   a maximum a posteriori decoder (932);
   said user-specific deinterleaver (358, 364) for each user in said forward signal path (936) between said first node (935) and said maximum a posteriori decoder (934);
   a second node (937) receiving deinterleaved information blocks from said user-specific deinterleaver (358, 364) and an a priory log-likelihood signal from said maximum a posteriori decoder (932);
   said user-specific interleaver (318, 324) for each user in said backward signal path (938) between said second node (937) and said multi-user detector (930).

8. Iterative multi-user detection circuit according to claim 6, wherein said further user-specific permuting means (356, 366.1 to 366.D) is arranged for user-specifically permuting information blocks according to a further user-specific permutation.

9. Iterative multi-user detection circuit according to claim 8, wherein said user-specific deinterleaver (364) comprises a sequence of units (362.1 to 362.D), each of said units (362.1 to 362.D) comprising said first user-specific permuting means (366.1 to 366.D) and said deinterleaver (352).

10. Method of user-specific interleaving information including a plurality of information blocks suitable for a transmission to a receiver, said method comprising the steps of:

interleaving of information blocks according to an interleaving algorithm, the interleaving algorithm being the same for a plurality of users; and
user-specific permuting of information blocks;
wherein said user-specific permuting (316, 316.1 to 316.D) is performed consecutive to said interleaving and permutes information blocks interleaved by said interleaver (312).

11. Method of iteratively processing information interleaved in a user-specific manner, said method comprising an iterative multi-user detection performing for each user:

a user-specific deinterleaving in a forward signal processing path (936) between a multi-user detector (930) and a maximum a posteriori decoder (932); and
a user-specific interleaving according to claim 10 in a backward signal processing path (938) between said maximum a posteriori decoder (932) and said multi-user detector (930);
wherein each user-specific deinterleaving comprises the steps of:

further user-specific permuting of information blocks, and
deinterleaving of information blocks according to a deinterleaving algorithm, which is the same for said plurality of users,

wherein said deinterleaving (352) is performed consecutive to said further user-specific permuting (356, 366.1 to 366.D) and deinterleaves information blocks permuted by said further user-specific permuting.

12. Method of exchanging user-specific interleaver parameters between a transmitter performing user-specific interleaving of information according to the method of claim 10 and a receiver iteratively processing information according to the method of claim 11, said method comprising the following steps:

generating the user-specific interleaver parameters at the transmitter (S2) randomly;
sending the user-specific interleaver parameters from the transmitter to the receiver (S3);
evaluating the received user-specific interleaver parameters at the receiver (S4); and
rejecting (S5) the user-specific interleaving parameters in case the received user-specific interleaver parameters interfere with user-specific interleaver parameters of another user, or an interference level is too high for said receivers capabilities to handle interference, or otherwise accepting the user-specific interleaving parameters;
wherein the user-specific interleaver parameters comprise information concerning a frequency for updating said user-specific interleaving parameters between said transmitter and said receiver.

13. Computer readable medium storing a computer program having program code for performing a method in accordance with claims 10 to 12, when the program runs on a computer.

**Patentansprüche**

1. Nutzerspezifische Verschachtelungsvorrichtung, die geeignet ist für eine Verwendung in einem Sender zum Erzeugen von Informationen einschließlich einer Mehrzahl von Informationsblöcken, die für eine Sendung an einen Empfänger geeignet sind, wobei die nutzerspezifische Verschachtelungsvorrichtung (318, 324) folgende Merkmale aufweist:

eine Verschachtelungsvorrichtung (312), die zum Verschachteln von Informationsblöcken gemäß einem Verschachtelungsalgorithmus angeordnet ist, wobei der Verschachtelungsalgorithmus für eine Mehrzahl von Nutzern derselbe ist; und
eine nutzerspezifische Permutationseinrichtung (316, 316.1 bis 316.D), die zum nutzerspezifischen Permutieren von Informationsblöcken angeordnet ist;

wobei die nutzerspezifische Permutationseinrichtung (316, 316.1 bis 316.D) konsekutiv zu der Verschachtelungsvorrichtung (312) angeordnet ist und zum Permutieren von Informationsblöcken, die durch die Verschachtelungsvorrichtung (312) verschachtelt sind, angeordnet ist.

2. Nutzerspezifische Verschachtelungsvorrichtung gemäß Anspruch 1, bei der die Permutationseinrichtung eine Verschiebungseinrichtung (316, 316.1 bis 316.D) aufweist, die zum zyklischen Verschieben der Informationsblöcke angeordnet ist.

3. Nutzerspezifische Verschachtelungsvorrichtung gemäß einem der Ansprüche 1 oder 2, wobei die nutzerspezifische Verschachtelungsvorrichtung (318, 324) eine Sequenz von Einheiten aufweist, von denen jede die Verschachtelungsvorrichtung (312) und die Permutationseinrichtung (316, 316.1 bis 316.D) aufweist.

4. Nutzerspezifische Verschachtelungsvorrichtung gemäß Anspruch 1, bei der die nutzerspezifische Permutationseinrichtung (316, 316.1 bis 316.D) zum nutzerspezifischen Permutieren von Informationsblöcken gemäß einer nutzerspezifischen Permutation angeordnet ist.

5. Nutzerspezifische Verschachtelungsvorrichtung gemäß Anspruch 4, wobei die nutzerspezifische Verschachtelungsvorrichtung (324) eine Sequenz von Einheiten (322, 322.1 bis 322.D) aufweist, wobei jede Einheit (322, 322.1 - 322.D) die Verschachtelungsvorrichtung (312) und die nutzerspezifische Permutationseinrichtung (316, 316.1 bis 316.D) aufweist.

6. Iterativmultinutzererfassungsschaltung zum iterativen Verarbeiten von Informationen, die auf eine nutzerspezifische Art verschachtelt sind, wobei die Iterativmultinutzererfassungsschaltung für jeden Nutzer folgende Merkmale aufweist:

eine nutzerspezifische Entschachtelungsvorrichtung (358, 364) in einem Vorwärtssignalweg (936) zwischen einem Multinutzerdetektor (930) und einem Maximum-A-Posteriori-Decodierer (932); und
eine nutzerspezifische Verschachtelungsvorrichtung (318, 324) gemäß einem der Ansprüche 1 bis 5 in einem Rückwärtssignalweg (938) zwischen dem Maximum-A-Posteriori-Decodierer (932) und dem Multinutzerdetektor (930);
wobei jede nutzerspezifische Entschachtelungsvorrichtung (358, 364) eine weitere nutzerspezifische Permutationseinrichtung (356, 366.1 bis 366.D), die zum nutzerspezifischen Permutieren von Informationsblöcken angeordnet ist, und eine Entschachtelungsvorrichtung (352) aufweist, die zum Entschachteln von Informationsblöcken für eine Mehrzahl von Nutzern gemäß einem Entschachtelungsalgorithmus angeordnet ist, wobei der Entschachtelungsalgorithmus für die Mehrzahl von Nutzern derselbe ist; und
wobei die Entschachtelungsvorrichtung (352) konsekutiv zu der weiteren nutzerspezifischen Permutationseinrichtung (356, 366.1 bis 366.D) angeordnet ist und zum Entschachteln von Informationsblöcken, die durch die weitere nutzerspezifische Permutationseinrichtung permutiert sind, angeordnet ist.

7. Iterativmultinutzererfassungsschaltung gemäß Anspruch 6, bei der der Empfänger einen Multinutzerdetektor (930) und eine Mehrzahl von nutzerspezifischen Iterativverarbeitungsschaltungen (932) aufweist, wobei jede Iterativverarbeitungsschaltung (933) folgende Merkmale aufweist:

einen ersten Knoten (935), der von dem Multinutzerdetektor (930) ein A-Posteriori-Log-Likelihood-Signal empfängt;
einen Maximum-A-Posteriori-Decodierer (932);
die nutzerspezifische Entschachtelungsvorrichtung (358, 364) für jeden Nutzer in dem Vorwärtssignalweg (936) zwischen dem ersten Knoten (935) und dem Maximum-A-Posteriori-Decodierer (934);
einen zweiten Knoten (937), der entschachtelte Informationsblöcke von der nutzerspezifischen Entschachtelungsvorrichtung (358, 364) und ein A-Priori-Log-Likelihood-Signal von dem Maximum-A-Posteriori-Decodierer (932) empfängt;
die nutzerspezifische Verschachtelungsvorrichtung (318, 324) für jeden Nutzer in dem Rückwärtssignalweg (938) zwischen dem zweiten Knoten (937) und dem Multinutzerdetektor (930).

8. Iterativmultinutzererfassungsschaltung gemäß Anspruch 6, bei der die weitere nutzerspezifische Permutationseinrichtung (356, 366.1 bis 366.D) zum nutzerspezifischen Permutieren von Informationsblöcken gemäß einer weiteren nutzerspezifischen Permutation angeordnet ist.

**9.** Iterativmultinutzererfassungsschaltung gemäß Anspruch 8, bei der die nutzerspezifische Entschachtelungsvorrichtung (364) eine Sequenz von Einheiten (362.1 bis 362. D) aufweist, wobei jede der Einheiten (362.1 bis 362.D) die erste nutzerspezifische Permutationseinrichtung (366.1 bis 366.D) und die Entschachtelungsvorrichtung (352) aufweist.

**10.** Verfahren zum nutzerspezifischen Verschachteln von Informationen einschließlich einer Mehrzahl von informationsbiöcken, die für eine Sendung an einen Empfänger geeignet sind, wobei das Verfahren die folgenden Schritte aufweist:

Verschachteln von Informationsblöcken gemäß einem Verschachtelungsalgorithmus, wobei der Verschachtelungsalgorithmus für eine Mehrzahl von Nutzern derselbe ist; und
nutzerspezifisches Permutieren von Informationsblöcken;
wobei das nutzerspezifische Permutieren (316, 316.1 bis 316.D) konsekutiv zu Verschachteln durchgeführt wird und Informationsblöcke, die durch die Verschachtelungsvorrichtung (312) verschachtelt sind, permutiert.

**11.** Verfahren zum iterativen Verarbeiten von Informationen, die auf eine nutzerspezifische Weise verschachtelt sind, wobei das Verfahren eine Iterativmultinutzererfassung aufweist, die für jeden Nutzer folgende Schritte durchführt:

ein nutzerspezifisches Entschachteln in einem Vorwärtssignalverarbeitungsweg (936) zwischen einem Multinutzerdetektor (930) und einem Maximum-A-Posteriori-Decodierer (932); und
ein nutzerspezifisches Verschachteln gemäß Anspruch 10 in einem Rückwärtssignalverarbeitungsweg (938) zwischen dem Maximum-A-Posteriori-Decodierer (932) und dem Multinutzerdetektor (930);
wobei jedes nutzerspezifische Entschachteln folgende Schritte aufweist:

ein weiteres nutzerspezifisches Permutieren von Informationsblöcken, und
Entschachteln von Informationsblöcken gemäß einem Entschachtelungsalgorithmus, der für die Mehrzahl von Nutzern derselbe ist,

wobei das Entschachteln (352) konsekutiv zu dem weiteren nutzerspezifischen Permutieren (356, 366.1 bis 366.D) durchgeführt wird und Informationsblöcke, die durch das weitere nutzerspezifische Permutieren permutiert sind, entschachtelt.

**12.** Verfahren zum Austauschen von nutzerspezifischen Verschachtelungsvorrichtungsparametern zwischen einem Sender, der ein nutzerspezifisches Verschachteln von Informationen gemäß dem Verfahren aus Anspruch 10 durchführt, und einem Empfänger, der Informationen gemäß dem Verfahren aus Anspruch 11 iterativ verarbeitet, wobei das Verfahren die folgenden Schritte aufweist:

Erzeugen der nutzerspezifischen Verschachtelungsvorrichtungsparameter an dem Sender (S2) auf zufällige Weise;
Senden der nutzerspezifischen Verschachtelungsvorrichtungsparameter von dem Sender an den Empfänger (S3);
Auswerten der empfangenen nutzerspezifischen Verschachtelungsvorrichtungsparameter an dem Empfänger (S4); und
Abweisen (S5) der nutzerspezifischen Verschachtelungsparameter, falls die empfangenen nutzerspezifischen Verschachtelungsvorrichtungsparameter mit nutzerspezifischen Verschachtelungsvorrichtungsparametern eines anderen Nutzers interferieren oder ein Interferenzpegel für die Fähigkeiten des Empfängers dahin gehend zu hoch ist, eine Interferenz handzuhaben, oder ansonsten Akzeptieren der nutzerspezifischen Verschachtelungsparameter;
wobei die nutzerspezifischen Verschachtelungsvorrichtungsparameter Informationen aufweisen, die eine Frequenz zum Aktualisieren der nutzerspezifischen Verschachtelungsparameter zwischen dem Sender und dem Empfänger betreffen.

**13.** Computerlesbares Medium, das ein Computerprogramm mit einem Programmcode zum Durchführen eines Verfahrens gemäß den Ansprüchen 10 bis 12 speichert, wenn das Programm auf einem Computer abläuft.

**EP 1 775 840 B1**

**Revendications**

1. Entrelaceur spécifique à l'utilisateur convenant pour être utilisé dans un émetteur pour la génération d'informations comportant une pluralité de blocs d'informations convenant pour une transmission à un récepteur, ledit entrelaceur spécifique à l'utilisateur (318, 324) comprenant:

   un entrelaceur (312) aménagé pour entrelacer les blocs d'informations selon un algorithme d'entrelaçage, l'algorithme d'entrelaçage étant le même pour une pluralité d'utilisateurs; et
   un moyen de permutation spécifique à l'utilisateur (316, 316.1 à 316.D) aménagé pour permuter des blocs d'informations de manière spécifique à l'utilisateur;
   dans lequel ledit moyen de permutation spécifique à l'utilisateur (316, 316.1 à 316.D) est disposé à la suite dudit entrelaceur (312) et aménagé pour permuter les blocs d'informations entrelacés par ledit entrelaceur (312).

2. Entrelaceur spécifique à l'utilisateur selon la revendication 1, dans lequel ledit moyen de permutation comprend un moyen de décalage (316, 316.1 à 316.D) aménagé pour décaler cycliquement lesdits blocs d'informations.

3. Entrelaceur spécifique à l'utilisateur selon l'une des revendications 1 ou 2, dans lequel ledit entrelaceur spécifique à l'utilisateur (318, 324) comprend une séquence d'unités comprenant, chacune, ledit entrelaceur (312) et ledit moyen de permutation (316, 316.1 à 316.D).

4. Entrelaceur spécifique à l'utilisateur selon la revendication 1, dans lequel ledit moyen de permutation spécifique à l'utilisateur (316, 316.1 à 316.D) est aménagé pour permuter des blocs d'informations de manière spécifique à l'utilisateur selon une permutation spécifique à l'utilisateur.

5. Entrelaceur spécifique à l'utilisateur selon la revendication 4, dans lequel ledit entrelaceur spécifique à l'utilisateur (324) comprend une séquence d'unités (322, 322.1 à 322.D), chaque dite unité (322, 322.1 à 322.D) comprenant ledit entrelaceur (312) et ledit moyen de permutation spécifique à l'utilisateur (316, 316.1 à 316.D).

6. Circuit de détection multi-utilisateur itératif pour traiter de manière itérative des informations entrelacées de manière spécifique à l'utilisateur, ledit circuit de détection multi-utilisateur itératif comprenant, pour chaque utilisateur:

   un désentrelaceur spécifique à l'utilisateur (358, 364) dans un trajet de signal en avant (936) entre un détecteur multi-utilisateur (930) et un décodeur de maximum à posteriori (932); et
   un entrelaceur spécifique à l'utilisateur (318, 324) selon l'une des revendications 1 à 5 dans un trajet de signal en arrière (938) entre ledit décodeur de maximum à posteriori (932) et ledit détecteur multi-utilisateur (930);
   dans lequel chaque désentrelaceur spécifique à l'utilisateur (358, 364) comprend un autre moyen de permutation spécifique à l'utilisateur (356, 366.1 à 366.D) aménagé pour permuter les blocs d'informations de manière spécifique à l'utilisateur, et un désentrelaceur (352) aménagé pour désentrelacer les blocs d'informations pour une pluralité d'utilisateurs selon un algorithme de désentrelaçage, l'algorithme de désentrelaçage étant le même pour la pluralité d'utilisateurs; et
   dans lequel ledit désentrelaceur (352) est disposé à la suite dudit autre moyen de permutation spécifique à l'utilisateur (356, 366.1 à 366.D) et aménage pour désentrelacer les blocs d'informations permutés par ledit autre moyen de permutation spécifique à l'utilisateur.

7. Circuit de détection multi-utilisateur itératif selon la revendication 6, ledit récepteur comprenant un détecteur multi-utilisateur (930) et une pluralité de circuits de traitement itératifs (932) spécifiques à l'utilisateur, chaque circuit de traitement itératif (933) comprenant:

   un premier noeud (935) recevant dudit détecteur multi-utilisateur (930) un signal de log-vraisemblance à posteriori;
   un décodeur de maximum à posteriori (932);
   ledit désentrelaceur (358, 364) spécifique à l'utilisateur étant prévu pour chaque utilisateur dans ledit trajet de signal en avant (936) entre ledit premier noeud (935) et ledit décodeur de maximum à posteriori (934);
   un deuxième noeud (937) recevant des blocs d'informations désentrelacés dudit désentrelaceur (358, 364) spécifique à l'utilisateur et un signal de log-vraisemblance à priori dudit décodeur de maximum à posteriori (932);
   ledit entrelaceur spécifique à l'utilisateur (318, 324) étant prévu pour chaque utilisateur dans ledit trajet de signal en arrière (938) entre ledit deuxième noeud (937) et ledit détecteur multi-utilisateur (930).

16

**8.** Circuit de détection multi-utilisateur itératif selon la revendication 6, dans lequel ledit autre moyen de permutation spécifique à l'utilisateur (356, 366.1 à 366.D) est aménagé pour permuter de manière spécifique à l'utilisateur les blocs d'informations selon une autre permutation spécifique à l'utilisateur.

**9.** Circuit de détection multi-utilisateur itératif selon la revendication 8, dans lequel ledit désentrelaceur spécifique à l'utilisateur (364) comprend une séquence d'unités (362.1 à 362.D), chacune desdites unités (362.1 à 362.D) comprenant ledit premier moyen de permutation spécifique à l'utilisateur (366.1. à 366.D) et ledit désentrelaceur (352).

**10.** Procédé d'entrelaçage d'informations spécifique à l'utilisateur comportant une pluralité de blocs d'informations convenant pour une transmission à un récepteur, ledit procédé comprenant les étapes consistant à:

entrelacer les blocs d'informations selon un algorithme d'entrelaçage, l'algorithme d'entrelaçage étant le même pour une pluralité d'utilisateurs; et
permuter de manière spécifique à l'utilisateur les blocs d'informations;
dans lequel ladite permutation spécifique à l'utilisateur (316, 316.1 à 316.D) est effectuée à la suite dudit entrelacer et permute les blocs d'informations entrelacés par ledit entrelaceur (312).

**11.** Procédé de traitement itératif d'informations entrelacées de manière spécifique à l'utilisateur, ledit procédé comprenant une détection multi-utilisateur itérative en effectuant pour chaque utilisateur:

un désentrelaçage spécifique à l'utilisateur dans un trajet de traitement de signal en avant (936) entre un détecteur multi-utilisateur (930) et un décodeur de maximum à posteriori (932); et
un entrelaçage spécifique à l'utilisateur selon la revendication 10 dans un trajet de traitement de signal en arrière (938) entre ledit décodeur de maximum à posteriori (932) et ledit détecteur multi-utilisateur (930);
dans lequel chaque désentrelaçage spécifique à l'utilisateur comprend les étapes consistant à:

permuter davantage de manière spécifique à l'utilisateur les blocs d'informations, et
désentrelacer les blocs d'informations selon un algorithme de désentrelaçage qui est le même pour ladite pluralité d'utilisateurs,

dans lequel ledit désentrelaçage (352) est effectué à la suite de ladite autre permutation (356, 366.1 à 366.D) spécifique à l'utilisateur et désentrelace les blocs d'informations permutés par ladite autre permutation spécifique à l'utilisateur.

**12.** Procédé d'échange de paramètres d'entrelaceur spécifiques à l'utilisateur entre un émetteur effectuant un entrelaçage spécifique à l'utilisateur d'informations selon le procédé de la revendication 10 et un récepteur traitant de manière itérative les informations selon le procédé de la revendication 11, ledit procédé comprenant les étapes suivantes consistant à:

générer les paramètres d'entrelaceur spécifiques à l'utilisateur de manière aléatoire à l'émetteur (S2);
envoyer les paramètres d'entrelaceur spécifiques à l'utilisateur de l'émetteur au récepteur (S3);
évaluer les paramètres d'entrelaceur spécifiques à l'utilisateur reçus au récepteur (S4); et
rejeter (S5) les paramètres d'entrelaceur spécifiques à l'utilisateur au cas où les paramètres d'entrelaceur spécifiques à l'utilisateur reçus interfèrent avec les paramètres d'entrelaceur spécifiques à l'utilisateur d'un autre utilisateur, ou en cas de niveau d'interférence trop élevé pour les capacités dudit récepteur de gérer les interférences, ou pour accepter autrement les paramètres d'entrelaçage spécifiques à l'utilisateur;
dans lequel les paramètres d'entrelaçage spécifiques à l'utilisateur comprennent des informations concernant une fréquence pour mettre à jour lesdits paramètres d'entrelaçage spécifiques à l'utilisateur entre ledit émetteur et ledit récepteur.

**13.** Support lisible par ordinateur, mémorisant un programme d'ordinateur présentant un code de programme pour réaliser un procédé selon les revendications 10 à 12 lorsque le programme est exécuté sur un ordinateur.

IDMA, 4 user, BPSK, 1/2 convolutional code, 1/4 repetition code

user synchronous (Fig. 1c)

Fig. 1a

user asynchronous (Fig. 1d)

Fig. 1b

AWGN
user synchrinous

— ×— random interleavers
— ⊖— common random interleaver

$E_b/N_0$ in dB

Fig. 1c

AWGN
user asynchrinous

$E_b/N_0$ in dB

Fig. 1d

IDMA, 4 user, BPSK, 1/2 convolutional code, 1/4 repetition code

Fig. 2a

Fig. 2b

Fig. 2c

Fig. 2d

common interleaver and user delay

$\pi$

312

$\tau_k$

314

similarity

common interleaver and cyclic shift

312

$\pi$

$\Delta_k^{(c)}$

316

$\pi_k$

318

315.1

$\tau_1 \ldots$ | 2 | 4 | 1 | 5 | 3 | 6 | $\ldots$

$\Delta\tau$

315.2

$\tau_2 \ldots$ | 2 | 4 | 1 | 5 | 3 | 6 | $\ldots$

**Fig. 3a**

319.1

$\Delta_1^{(c)} \ldots$ | 2 | 4 | 1 | 5 | 3 | 6 | $\ldots$

319.2

$\Delta_2^{(c)} \ldots$ | 1 | 5 | 3 | 6 | 2 | 4 | $\ldots$

**Fig. 3b**

(c) repeat (b) with multiple cyclic shifts

Fig. 3c

352
356

$\pi^{-1}$ ← $\Delta_k^{(-c)}$

$\pi_k^{-1}$

358

Fig. 3d

352
366.1

$\pi^{-1}$ ← $\Delta_{k,1}^{(-c)}$

362.1

. . .

352
366.d

$\pi^{-1}$ ← $\Delta_{k,D}^{(-c)}$

362.d

$\pi_k^{-1}$

364

Fig. 3e

Fig. 4

4 synchronous users, 1/2 convolutional code, 1/4 repetition code
Randomly generated 2 cyclic shifts are used for each user

Fig. 5a

Fig. 5b

6 synchronous users, AWGN, 1/2 convolutional code, 1/4 repetition code
one common turbo interleaver is utilized
influence of the number of randomly generated cyclic shifts

Fig. 6

110 synchronous users, AWGN, 1/64 repetition code
Randomly generated 3 cyclic shifts are used for each user

Fig. 7

idle
no data —S1

generate
random seed s —S2

reject request

exchange
(s, f, n) —S3

—S5

—S4

accept?

{ no collision of seeds?
new user can be supported?
etc.

—S7

transmit data &
update interleaver —S6

s: random seed
f: update frequency
n: # of cyclic shifts

Fig. 8

CDMA  $b^{(k)}$  → | 912 Convolutional encoder |  $C_{n,\ m}^{(k)}$  → | 914 $\pi_k$ | → | 916 Symbol mapper |  $S_n^{(k)}$  → ⊕ →  $X_i^{(k)}$ 

918  $U_n^{(k)}$ 

Fig. 9a

IDMA  $b^{(k)}$  → | 912 Convolutional encoder | → | 913 Rep. |  $C_{n,\ m}^{(k)}$  → | 914 $\pi_k$ | → | 916 Symbol mapper |  $S_n^{(k)}$  → | 920 $\pi'_k$ | →  $X_i^{(k)}$ 

Fig. 9b

common receiver structure  $y_i$  → | 930 MUD | → 935 ⊕ → 936 → | 934 $\pi_k^{-1}$ | → | 932 decoder | →  $L(b^{(k)})$ 

| 914 $\pi_k$ |

for K users

938    937 ⊕

Fig. 9c

## REFERENCES CITED IN THE DESCRIPTION

### Patent documents cited in the description

- WO 2004114536 A
- EP 1154577 A

- US 20040240378 A1

### Non-patent literature cited in the description

- **S. BRÜCK ; U. SORGER ; S. GLIGOREVIC ; N. STOLTE.** Interleaving for outer convolutional codes in DS-CDMA systems. *IEEE Transactions on Communications,* July 2000, vol. 48 (7), 1100-1107
- **G. MONTORSI ; S. BENEDETTO.** Analysis and design of interleavers for iterative multi-user receivers in coded CDMA systems. *IEEE Transactions on Information Theory,* May 2005, vol. 51 (5), 1650-1666
- **L. PING ; L. LIU ; K. Y. WU ; W. K. LEUNG.** Interleave-division multipleaccess. *IEEE Transaction on Wireless Communications*
- **H. SCHOENEICH ; P. A. HOEHER.** Adaptive interleave-division multiple access - a potential air interface for 4G bearer services and wireless LANs. *Proc. 1st IEEE and IFIP Int. Conf. on Wireless and Optical Communications and Networks (WOCN '2004),* June 2004, 179-182

- **K. KUSUME ; G. BAUCH.** CDMA and IDMA: Iterative multi-user detections for near-far asynchronous communications. *Proc. IEEE Int. Symposium on Personal, Indoor and Mobile Radio Communications (PIMRC 2005),* September 2005
- **L. R. BAHL ; J. COCKE ; F. JELINEK ; J. RAVIV.** Optimal decoding of linear codes for minimizing symbol error rate. *IEEE Transactions on Information Theory,* March 1974, vol. 20 (2), 284-287
- 3rd generation partnership project; technical specification group radio access network; multiplexing and channel coding (FDD). *3G TS 25.212,* 1999
- **S. CROZIER ; J. LODGE ; P. GUINAND ; A. HUNT.** Performance of turbocodes with relative prime and golden interleaving strategies. *Proceedings of the International Mobile Satellite Conference,* 1999, 268-275
- **BAUCH G. et al.** *Parameter Optimization, Interleaving and Multiple Access in OFDM with Cyclic Delay Diversity*